Europäisches Patentamt

European Patent Office

Office européen des brevets

(11) Publication number: **0 090 633**
**B1**

# EUROPEAN PATENT SPECIFICATION

(45) Date of publication of patent specification: **19.07.89**

(51) Int. Cl.⁴: **H 01 L 23/36**

(21) Application number: **83301736.1**

(22) Date of filing: **28.03.83**

(54) Semiconductor device having radiator.

(30) Priority: **29.03.82 JP 50733/82**

(43) Date of publication of application:
**05.10.83 Bulletin 83/40**

(45) Publication of the grant of the patent:
**19.07.89 Bulletin 89/29**

(84) Designated Contracting States:
**DE FR GB**

(56) References cited:
**EP-A-0 035 390**
**US-A-2 994 017**
**US-A-4 292 647**

**IBM TECHNICAL DISCLOSURE BULLETIN, vol. 23, no. 9, February 1981, pages 4222-4223, New York, US; S.W. NUTTER et al.: "Center-post heat sink"**

(73) Proprietor: **FUJITSU LIMITED**
**1015, Kamikodanaka Nakahara-ku**
**Kawasaki-shi Kanagawa 211 (JP)**

(72) Inventor: **Wakabayashi, Tetshushi**
**780-1, Minowa-cho Kohoku-ku**
**Yokohama-shi Kanagawa 223 (JP)**
Inventor: **Sugimoto, Masahiro**
**5-27-13, Shonantakatori**
**Yokosuka-shi Kanagawa 237 (JP)**
Inventor: **Muratake, Kiyoshi**
**861-1, Kamikodanaka Nakahara-ku**
**Kawasaki-shi Kanagawa 211 (JP)**

(74) Representative: **Fane, Christopher Robin King et al**
**HASELTINE LAKE & CO. Hazlitt House 28**
**Southampton Buildings Chancery Lane**
**London, WC2A 1AT (GB)**

Courier Press, Leamington Spa, England.

## Description

The present invention relates to a semiconductor device. More particularly, it relates to an improvement in a radiator for cooling a semiconductor chip which generates a large amount of heat.

A radiator is attached to a semiconductor integrated-circuit (IC) package which houses an IC chip which generates a large amount of heat. Such a radiator comprises a pillar and a plurality of fins disposed on the pillar. The pillar is secured to a molded body of plastic or a ceramic body which houses the IC chip. The size of the fins corresponds to the size of the IC package and is not uniform.

A device including such a radiator, in which a threaded pillar or stud attached to a ceramic substrate on which the chip is mounted passes through a central longitudinal hole in the radiator and the radiator is held in position by a nut and lock washer at the top of the threaded pillar, is disclosed in IBM Technical Disclosure Bulletin, vol. 23, No. 9, Feb. 1981, pp. 4222-3.

Another such device is disclosed in US—A—4 292 647. In this device the radiator pillar is generally solid but is shown in the drawings as having a longitudinal hole extending a short distance into its upper end. The lower end of the radiator is adhesively secured to a heat conductive plate secured in turn to the chip, and is surrounded by a sealing ring to hermetically seal the chip.

IBM Technical Disclosure Bulletin, vol. 20, No. 4, Sept. 1977, p. 1472, discloses an alternative way of securing a heat sink to a ceramic module, said to give improved heat conductivity and thermal contact, which employs molybdenum studs inserted into the substrate and heat sink and brazed or welded thereto.

A number of semiconductor devices, each of which comprises an IC package and a radiator, are densely mounted on a printed circuit board. It is inconvenient to handle such small-sized semiconductor devices, and, also it is difficult to place them in a predetermined position when mounting them on a printed board. In addition, it is troublesome to remove the semiconductor devices from the printed board if it is necessary to replace them. Furthermore, it is difficult to distinguish one kind of semiconductor device from another when different kinds of semiconductor devices are to be mounted on the printed board since the semiconductor devices are all virtually the same size. In order to make the semiconductor device easy to handle, when the semiconductor devices are to be disposed close to each other on the printed board, a projection could be formed on the uppermost fin for picking up the semiconductor device or the uppermost fin could be removed so as to give access to the pillar for picking up the semiconductor device. However, it is not desirable to form such a projection since this would increase the height of the semiconductor device, and prevent the semiconductor device from being mounted on a printed board which has little space above its upper surface. Also, it is not desirable to remove the uppermost fin since the efficiency of radiation of heat is degraded.

The present invention takes the above-mentioned problems into consideration. An object of the present invention is to provide a semiconductor device having a radiator, the device being easy to handle and thereby rendering the positioning thereof and the replacing thereof easy without degrading the efficiency of the radiation of heat.

A semiconductor device according to an embodiment of the present invention comprises a semiconductor package which houses a semiconductor chip therein; and a radiator comprising a pillar and a plurality of fins extending from said pillar, one end of said pillar being bonded to said semiconductor package, wherein said stud extends only into the lower part of said hole and is secured therein with an adhesive agent, said stud is electrically conducting and is in electrical contact at its lower end with said chip via an electrically conducting base plate of the package, and the upper end of said stud is accessible for electrical contact through the upper part of said hole.

A preferred embodiment of the invention will now be described by way of example with reference to the accompanying drawings, in which:

Fig. 1 is a perspective view of an example of the semiconductor device according to the present invention.

Fig. 2 is a sectional view of the semiconductor device according to the present invention.

Fig. 3 is a plan view of a printed board on which semiconductor devices of the present invention are mounted.

Fig. 4 is a partial sectional view of a semiconductor device which does not fall within the terms of the present invention.

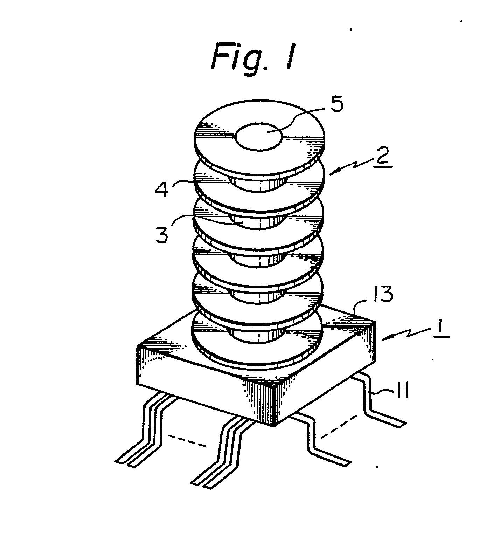

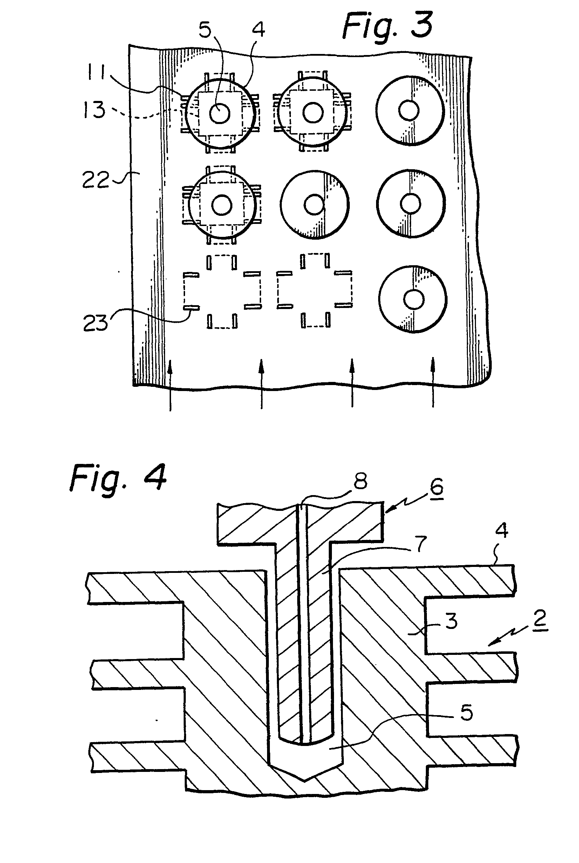

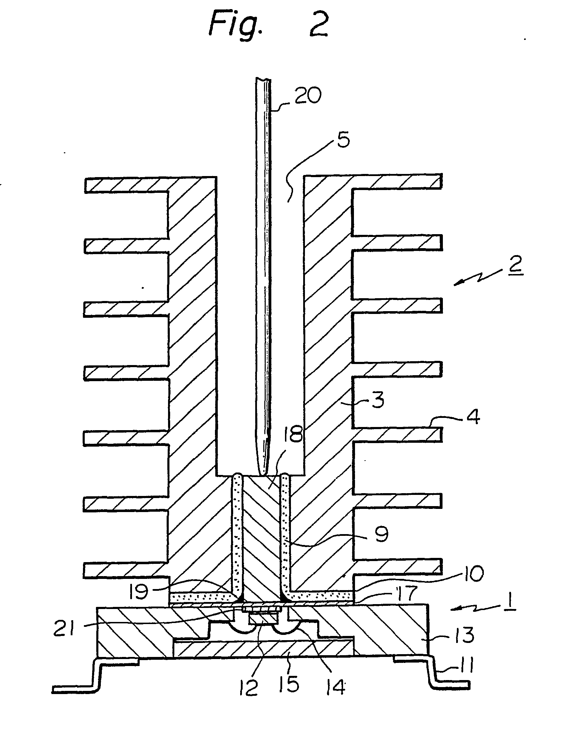

The semiconductor device according to the present invention comprises a semiconductor package 1 and a radiator 2, as is illustrated in Fig. 1. The semiconductor package 1 comprises a base body 13 and lead terminals 11. A semiconductor chip 12 is housed within a cavity 26 of the base body 13 and is covered by a cap 15 as is shown in Fig. 2. The semiconductor chip 12 is connected to printed circuit patterns 27 formed within the base body 13 by wires 14. The radiator 2 comprises a cylindrical pillar 3 provided with a plurality of fins 4 thereon. The pillar 3 and the fins 4 are made of aluminium, copper, molybdenum, or the like. A metal plate 17 of molybdenum is disposed on the upper surface of the IC package 1. A metal stud 18 is bonded onto the metal plate 17 with a soldering agent 19. The IC chip 12 is attached to the metal plate 17 through a metal base 21. Therefore, the back surface of the IC chip 12 is electrically connected to the stud 18. A hole 5 is formed in the upper end of the pillar 3 of the radiator 2 and extends longitudinally of the pillar 3. A second hole 9, small in diameter and corresponding to the diameter of the stud 18, is formed in the lower portion of the pillar 3 in series with the hole 5. The radiator 2 is attached to the IC package 1 by inserting the stud 18 into the second hole 9 of the radiator 2 and bonding it to the IC package with an adhesive agent 10.

Due to this construction, the hole 5 is convenient not only for picking up the semiconductor device but also for inserting a probe 20 into it so as to make electrical contact with the IC chip 12 through the stud 18. The function of the IC chip 12 can be easily tested since power can be supplied to the IC chip 12 through the probe 20 instead of through the lead terminal 11.

A vacuum chuck is used to handle the semiconductor device such a chuck is indicated by 6 in Fig. 4, which shows a radiator outside the scope of the present invention. An access end 7 of the vacuum chuck 6 is inserted into the hole 5. Vacuum is applied through a vacuum passage 8 so that the semiconductor device is sucked and held by the vacuum chuck 6. The semiconductor device sucked and held by the vacuum chuck 6 is picked up and is conveyed to, for example, a printed circuit board 22, illustrated in Fig. 3. The semiconductor device is disposed where pad patterns 23 are formed by placing each lead terminal 11 on a corresponding pad pattern 23. Then the lead terminals 11 are soldered to the pad patterns 23. The semiconductor device can be automatically conveyed to and placed in a predetermined position by an automatic positioning machine provided with a vacuum chuck. It is desirable that the diameter of the fins 4 is large enough to cover the base body 13 of the semiconductor package but is less than the width between the ends of the lead terminals on opposite sides of the base body 13. Therefore, positioning of the semiconductor device is easy since the operator can see the lead terminals 11 and the pad patterns 23. When an automatic positioning machine is used, the diameter of the fins 4 may be increased to a degree in which the fins of the adjacent semiconductor devices do not contact each other, thereby enhancing the efficiency of heat radiation. Cooling air is supplied, as is illustrated by the arrows in Fig. 3, to the printed board 22, on which a number of semiconductor devices are mounted. Disc-shaped fins are desirable for decreasing the resistance to the flow of the cooling air. Disc-shaped fins are also desirable from the viewpoint of production.

A tweezers shaped instrument which has obliquely crossed ends may be used instead of a vacuum chuck to pick up the semiconductor device. The ends of the tweezer-shaped instrument is inserted into the hole 5 of the radiator 2. Then the inserted ends of the instrument are opened by hand or by an appropriate spring means so as to push against the inside surface of the hole 5 so that the semiconductor device can be picked up by the instrument.

It is preferable to form the hole 5 in such a manner that one type of IC package can be distinguished from another according to the depth of the hole 5. If this is done, the type of IC package can be distinguished by the inserted length of the vacuum chuck or by measuring the depth of the hole 5 with an appropriate instrument. Not only does this make it easy for an operator to distinguish an IC package, it also makes possible the automatic distinguishing of an IC package.

The inventors performed an experiment in which it was confirmed that the hole 5 and the second hole 9 do not affect the efficiency of heat radiation of the radiator. The reason for this is that amount of heat to be radiated from the upper portion of the pillar is small since a large amount of heat conducted from the IC package is radiated through fins provided on the lower portion of the pillar. That is, the amount of heat conducted through the upper portion of the pillar is small while the amount of heat conducted through the pillar near the bonding portion between the pillar 3 and the base body 13 is large. Therefore, the efficiency of heat radiation of the radiator provided with a hole in the upper portion of the pillar is not degraded as compared with the radiator without such a hole.

The type of IC package is not limited to a flat package in which lead terminals are soldered onto the surface of the printed board. Any type of IC package, such as a package in which lead terminals are inserted into through holes of the printed board, may be used.

As was mentioned above, the radiator according to the present invention makes it possible to easily handle the semiconductor device and to easily distinguish each IC package. With the semiconductor device of the present invention, an IC package can be easily and precisely placed in a predetermined position. In addition, an IC package can be automatically positioned. This is especially advantageous when a number of semiconductor devices are to be densely mounted on a printed board.

## Claims

1. A semiconductor device comprising a semiconductor package (1) which houses a semiconductor chip (12) therein; and a radiator (2) comprising a pillar (3) and a plurality of fins (4) extending from said pillar, said pillar having a hole (5) extending longitudinally therethrough to accommodate a stud (18) projecting from said package and securing said radiator to said package, characterised in that said stud extends only into the lower part of said hole and is secured therein with an adhesive agent (10), said stud is electrically conducting and is in electrical contact at its lower end with said chip via an electrically conducting base plate (21, 17) of the package, and the upper end of said stud is accessible for electrical contact through the upper part of said hole (5).

2. A semiconductor device according to claim 1 wherein said adhesive agent extends between the bottom of said pillar and said base plate (17).

3. A semiconductor device according to claim 1 wherein each of said fins has a disc shape.

4. A printed circuit board having different kinds of semiconductor devices according to any preceding claims mounted thereon, wherein devices of different kinds are distinguished by different depths of the upper part of the hole (5) therein.

## Patentansprüche

1. Halbleitervorrichtung mit einer Halbleiterpakkung (1) in welcher ein Halbleiterchip (12) untergebracht ist; und einen Radiator (2), der eine Säule (3) und eine Vielzahl von Rippen (4) umfaßt, die sich von der genannten Säule erstrecken, welche Säule ein Loch (5) hat, welches sich in Längsrichtung durch sie hindurch erstreckt, um einen Stumpf (18) auf aufzunehmen, welcher von der genannten Packung vorsteht und den genannten Radiator an der genannten Packung sichert, dadurch gekennzeichnet, daß der Stumpf sich lediglich in den unteren Teil des hohlen Loches erstreckt und darin mit einem Klebstoff (10) gesichert ist, der genannte Stumpf elektrische leitend ist und an seinem unteren Ende mit dem genannten Chip über eine elektrisch leitende Basisplatte (21, 17) der Packung in elektrischem Kontakt ist, und das obere Ende des genannten Stumpfes durch den oberen Teil des genannten Loches (5) für den elektrischen Kontakt zugänglich ist.

2. Halbleitervorrichtung nach Anspruch 1, bei der der genannte Klebstoff sich zwischen dem Boden der genannte Säule und der genannten Basisplatte (17) erstreckt.

3. Halbleitervorrichtung nach Anspruch 1, bei der jede der genannten Rippen eine Scheibenform hat.

4. Dedruckte Schaltungskarte, auf der verschiedene Arten von Halbleitervorrichtungen nach einem der vorhergehenden Ansprüche montiert sind, bei welcher die Vorrichtungen der verschiedenen Arten sich durch verschiedene Tiefen des oberen Teils des Loches (5) darin unterscheiden.

## Revendications

1. Dispositif à semiconducteur, comprenant un boîtier de semiconducteur (1), dans lequel une plaquette de semiconducteur (12) est logée; et un radiateur (2) comportant une colonne (3) et une pluralité d'ailettes (4) en saillie depuis ladite colonne, cette colonne ayant un trou (5) qui s'y étend longitudinalement pour recevoir une colonnette (18) formant saillie depuis ledit boîtier et solidarisant ledit radiateur audit boîtier, caractérisé en ce que ladite colonnette ne s'étend que dans la partie inférieure dudit trou et est fixée dans celui-ci par un agent adhésif (10), ladite colonnette étant électriquement conductrice et étant, à son extrémité inférieure, en contact électrique avec ladite plaquette via une plaque de base électriquement conductrice (21, 17) du boîtier, et l'extrémité supérieure de ladite colonnette étant accessible via la partie supérieure dudit trou (5), pour l'établissement d'un contact électrique.

2. Dispositif à semiconducteur selon revendication 1, dans lequel ledit agent adhésif s'étend entre le fond de ladite colonne et ladite plaque de base (17).

3. Dispositif à semiconducteur selon revendication 1, dans lequel chacune desdites ailettes possède une forme discoïdale.

4. Carte à circuit imprimé, ayant, montés sur elle, différentes types de dispositifs à semiconducteur selon l'une quelconque des revendications précédentes, les dispositifs de types différents étant distingués par différentes profondeurs de la partie supérieure du trou (5) qu'ils comportent.

# Fig. 1

*Fig. 3*

5  4

11

13

22

23

*Fig. 4*

8  6

7  4

3  2

5

2

# Fig. 2